# EUROPÄISCHE PATENTANMELDUNG

(11) **EP 3 190 790 A1**
(43) Veröffentlichungstag der Anmeldung: **12.07.2017**
(21) Anmeldenummer: 16150760.3
(22) Anmeldetag: 11.01.2016
(51) Int. Cl.: H04N 9/31, G02B 27/10

(54) **VERFAHREN ZUR HERSTELLUNG EINES LICHTMODULS, LICHTMODUL SOWIE VERFAHREN ZU BETREIBEN EINES LICHTMODULS UND COMPUTERPROGRAMM-PRODUKT**

(71) Anmelder: Fisba AG, 9016 St. Gallen (CH); ROBERT BOSCH GMBH, 70442 Stuttgart (DE)
(72) Erfinder: Moser, Hansruedi, 9452 Hinterforst (CH); Ehlert, Alexander, 73527 Schäwbisch Gmünd (DE); Fischer, Frank, 72810 Gomaringen (DE); Wäspi, Marcel, 9312 Häggenschwil (CH); Spring, Patrick, 9403 Goldach (CH)
(74) Vertreter: Hepp Wenger Ryffel AG

(57) **Zusammenfassung**

Ein Verfahren zur Herstellung eines Lichtmoduls (1) umfasst die folgenden Schritte: Platzieren, insbesondere Einpressen von mindestens zwei, bevorzugt drei, Lichtquellen (2a, 2b, 2c, 2d), insbesondere Laserdioden, in eine Lichtquellenhalterung (3), insbesondere Diodenhalterung. Setzen einer Strahlkombinationsvorrichtung (4), welche mindestens einen dichroitischen Spiegel (5) pro Laserdiode umfasst, wobei die jeweiligen dichroitischen Spiegel (5) einen Abstand zueinander aufweisen. Platzieren von jeweils einer Kollimationslinse (6) vor den Laserdioden auf einer Bodenplatte (7), so dass das aus den Laserdioden emittierte Licht kollimiert wird, bevorzugt mit einer Kollimationslinse (6) in einem Positionierungsmodul (8), wobei die dichroitischen Spiegel (5) gleichzeitig auf die Bodenplatte (7) aufgesetzt werden.

## Beschreibung

Die Erfindung betrifft ein Verfahren zur Herstellung eines Lichtmoduls, ein Lichtmodul sowie ein Verfahren zu Betreiben eines Lichtmoduls und ein Computerprogrammprodukt gemäss dem Oberbegriff der unabhängigen Ansprüche.

Es sind bereits Lichtmodule bekannt, bei denen Licht unterschiedlicher Wellenlängen in einem Strahl kombiniert wird und dann auf eine Projektionsfläche gelenkt wird.

Aus der WO 2014/023322 ist beispielsweise ein Projektionsmodul bekannt, welches drei Lichtquellen auf je einen dichroitischen Spiegel richtet, wobei das emittierte Licht aus den Lichtquellen durch die dichroitischen Spiegel zu einem Strahl kombiniert wird. Der kombinierte Strahl wird auf einen MEMS-Spiegel geführt, der den Lichtstrahl dann auf eine Projektionsoberfläche lenkt. Um ein klares, nicht verzerrtes Bild zu erreichen, werden die dichroitischen Spiegel während der Herstellung einzeln positioniert und ihre Positionen und Lage derartig angepasst, dass die jeweilige Lichtfarbe genau über der zweiten und dritten Lichtfarbe liegt. Ein derartiges Herstellungsverfahren ist sehr aufwendig und teuer.

Es ist daher Aufgabe der Erfindung ein Lichtmodul sowie ein Verfahren zur Herstellung eines Lichtmoduls zu schaffen, welches die Nachteile des Standes der Technik vermeidet. Insbesondere ist es Aufgabe der Erfindung ein Verfahren und ein Lichtmodul zu schaffen, welches kostengünstig herstellbar ist.

Die Aufgabe wird mit den kennzeichnenden Merkmalen der unabhängigen Ansprüche gelöst.

Insbesondere wird die Aufgabe durch ein Verfahren zur Herstellung eines Lichtmoduls gelöst, welches die folgenden Schritte umfasst:
- Platzieren, insbesondere Einpressen von mindestens zwei, bevorzugt drei, Lichtquellen, insbesondere Laserdioden, in eine Lichtquellenhalterung, insbesondere Diodenhalterung,
- Setzen einer Strahlkombinationsvorrichtung, welche mindestens einen dichroitischen Spiegel pro Laserdiode umfasst, wobei die jeweiligen dichroitischen Spiegel einen Abstand zueinander aufweisen,
- Platzieren von jeweils einer Kollimationslinse vor den Laserdioden auf einer Bodenplatte, so dass das aus den Laserdioden emittierte Licht kollimiert wird, bevorzugt mit einer Kollimationslinse in einem Positionierungsmodul.
   Die dichroitischen Spiegel werden gleichzeitig auf die Bodenplatte aufgesetzt.

Durch das gleichzeitige Aufsetzen der dichroitischen Spiegel wird für das Setzen der dichroitischen Spiegel nur ein Arbeitsschritt benötigt, sodass die Herstellkosten signifikant gesenkt werden.

Ein Positionierungsmodul ist so ausgebildet, dass es eine einfache Positionierung der Kollimationslinse erlaubt, während die Lichtquelle und bevorzugt auch die Strahlkombinationsvorrichtung bereits im Gehäuse befestigt ist. Das Positionierungsmodul ist bevorzugt ein Teil der Vorrichtung und verbleibt auch nach der Herstellung im Gehäuse. Das Positionierungsmodul weist bevorzugt eine Dimensionierung von maximal 3x3x3 mm auf.

Das Positionierungsmodul kann ein Würfel oder ein sechsseitiges Prisma sein. Möglich wären auch ein acht- oder mehrseitiges Prisma. Die einzelnen Mantelflächen des Prismas dienen hierbei als Standflächen für das Prisma, so dass beispielsweise bei einem sechsseitigen Prisma sechs Standflächen ausgebildet sind.

Ein Positionierungsmodul hat eine Frontseite und eine Rückseite, wobei die Frontseite zu der Lichtquelle hin orientiert ist und die Rückseite von der Lichtquelle weg. Front- und Rückseite sind durch Seitenflächen verbunden, auf denen das Positionierungsmodul aufsetzbar ist. Zwischen Front- und Rückseite ist eine Kollimierungslinse angeordnet, so dass das Licht aus der Lichtquelle durch die Kollimierungslinse durchstrahlbar ist. Die Kollimationslinse im Positionierungsmodul ist exzentrisch angeordnet, so dass ein Abstand zwischen Kollimationslinse und den einzelnen Seitenflächen unterschiedlich ist.

Die einzelnen dichroitischen Spiegel können so gesetzt werden, dass ihre Position und Lage innerhalb eines vordefinierten Toleranzbereiches voneinander angeordnet ist, wobei der Toleranzbereich im Bereich von +/- 0.01 mm, insbesondere +/- 0.005 mm, in der Position der dichroitischen Spiegel voneinander und/oder die Lage im Bereich +/- 4 mrad, insbesondere +/- 2 mrad bezüglich der Normalen der Bodenplatte und/oder bezüglich eines anderes dichroitischen Spiegels liegt.

Ein derartiger Toleranzbereich ermöglicht eine für bestimmte Anwendungen ausreichende Genauigkeit oder die Möglichkeit, diese Toleranzen nachträglich noch zu korrigieren.

Die Position der dichroitischen Spiegel voneinander im Rahmen der Erfindung bedeutet, dass der Abstand zwischen den einzelnen Spiegeln einander derartig entspricht, dass die Abstände innerhalb des angeführten Toleranzbereiches gleich sind. Für den Fall dass auch die Lage von einer Normalen abweicht, werden die Positionen der Spiegel an ihrer Position zur Bodenplatte hin am unteren Rand des dichroitischen Spiegels gemessen und wenn nötig als Einheit ausgerichtet.

Gleichzeitig mit der Strahlkombinationsvorrichtung kann weiterhin ein Strahlformungsmodul, insbesondere ein Prismenteleskop, auf die Bodenplatte aufgesetzt werden. Bevorzugt berühren sich die Prismen des Prismenteleskopes nicht.

Durch gleichzeitiges Aufsetzen des Strahlformungsmoduls werden die Herstellkosten weiter optimiert.

Einzelne Elemente des Strahlformungsmoduls werden in einem Toleranzbereich voneinander und bevorzugt von der Strahlkombinationsvorrichtung gesetzt. Der Toleranzbereich kann im Bereich von +/- 0.01 mm, insbesondere +/- 0.005 mm, in der Position der Elemente des Strahlformungsmoduls und bevorzugt von den dichroitischen Spiegel und die Lage im Bereich von +/- 4mrad, insbesondere +/- 2 mrad, bezüglich der Normalen der Bodenplatte und/oder bezüglich eines dichroitischen Spiegels liegen.

Die Anordnung eines Strahlformungsmoduls innerhalb eines derartigen Toleranzbereiches ermöglicht eine ausreichende Genauigkeit für bestimmte Anwendungen. Weiterhin erlaubt dieser Toleranzbereich eine nachträgliche Korrektur.

Die Anordnung der Strahlkombinationsvorrichtung und bevorzugt auch das Strahlformungsmodul kann an einer der Lichtquellen ausgerichtet werden.

Somit ist zumindest eine der Lichtquellen optimal ausgerichtet und die Genauigkeit wird erhöht ohne die Herstellkosten zu erhöhen.

Ein oder mehrere MEMS-Spiegel können so gesetzt werden, dass das emittierte Licht aus den Laserdioden nach Durchlaufen der Strahlkombinationsvorrichtung und des Strahlformungsmoduls auf den oder die MEMS-Spiegel trifft.

Durch einen oder mehrere MEMS-Spiegel kann das Licht aus dem Lichtmodul heraus projiziert werden und ein Bild erzeugt werden.

Abweichungen des emittierten Lichtes einer Lichtquelle bezüglich des emittierten Lichtes einer weiteren Lichtquelle können durch eine digitale Korrektur der Videodaten vor der Lichtquellenansteuerung korrigiert werden, sodass ein optimal überlagerter Strahl aus emittiertem Licht der Lichtquellen entsteht.

Somit wird das Lichtmodul mit optimierten Herstellerkosten hergestellt und gleichzeitig ein derartig genauer Strahl auf eine Projektionsfläche projiziert, dass keine Verzerrungen oder Unschärfen entstehen.

Die Aufgabe wird weiterhin durch ein Lichtmodul zur Erzeugung von Licht gelöst, die eine Lichtquellenhalterung, insbesondere Diodenhalterung, mit mindestens zwei, bevorzugt drei Lichtquellen, insbesondere Laserdioden, bevorzugt eingepresste Laserdioden, umfasst. Das Modul umfasst jeweils eine Kollimationslinse pro Laserdiode, bevorzugt je eine Kollimationslinse in je einem Positionierungsmodul, und eine Strahlkombinationsvorrichtung, die jeweils einen dichroitischen Spiegel pro Laserdiode zur Kombination des von den jeweiligen Laserdioden emittierten Lichtes umfasst. Die Lichtquellenhalterung, die Kollimationslinsen und die Strahlkombinationsvorrichtung sind bevorzugt auf einer Bodenplatte angeordnet. Die dichroitischen Spiegel sind innerhalb eines vordefinierten Toleranzbereiches voreinander angeordnet und weisen einen Abstand zueinander auf, wobei der Toleranzbereich im Bereich von +/- 0.01 mm, insbesondere +/- 0.005 mm, in der Position der dichroitischen Spiegel voneinander und/oder die Lage im Bereich von +/- 4 mrad, insbesondere +/- 2mrad bezüglich der Normalen der Bodenplatte und/oder bezüglich eines anderen dichroitischen Spiegels liegt.

Ein derartiges Lichtmodul ist kostengünstig herstellbar.

Das Lichtmodul kann ein Strahlformungsmodul umfassen, bevorzugt ein Prismenteleskop, welches bevorzugt auf der Bodenplatte angeordnet ist.

Durch ein Strahlformungsmodul wird der kombinierte Strahl in seiner Form optimiert.

Das Lichtmodul kann eine Lichtquellensteuerung umfassen, durch die die Lichtquellen steuerbar sind. Durch die Lichtquellensteuerung kann Zeitpunkt und Intensität jeder einzelnen Lichtquelle individuell bestimmt werden.

Das Lichtmodul kann einen oder mehrere MEMS-Spiegel umfassen, der bevorzugt auf der Bodenplatte angeordnet ist.

Durch den oder die MEMS-Spiegel kann der kombinierte Strahl aus dem Lichtmodul herausprojiziert werden, sodass der Strahl beweglich ist und ein vollständiges Bild erzeugen kann. Bevorzugt ist auch der oder die MEMS-Spiegel durch die Lichtquellensteuerung steuerbar.

Einzelne Elemente des Strahlformungsmoduls können in einem Toleranzbereich voneinander und bevorzugt von der Strahlkombinationsvorrichtung angeordnet sein. Der Toleranzbereich kann im Bereich von +/- 0.01 mm, insbesondere +/- 0.005 mm, in der Position der Elemente des Strahlformungsmoduls und bevorzugt von den dichroitischen Spiegeln und/oder die Lage im Bereich von +/mrad, insbesondere +/- 2 mrad, bezüglich der Normalen der Bodenplatte und/oder bezüglich eines dichroitischen Spiegels liegen.

Eine in einem derartigen Toleranzbereich positionierte Strahlkombinationsvorrichtung ermöglicht eine optimierte Formung des kombinierten Strahles und ist gleichzeitig kostengünstig montierbar.

Das Strahlformungsmodul kann einzelne Elemente aus mindestens zwei unterschiedlichen Glasmaterialien umfassen.

Unterschiedliche Glasmaterialien im Rahmen dieser Erfindung sind Gläser mit unterschiedlichem Brechzahlindex und/oder unterschiedlicher Dispersion. Durch die Verwendung unterschiedlicher Materialien wird die Aufspaltung der Farben, also der Versatz untereinander, durch das Prismenteleskop verringert.

Es können zumindest eine rote, eine grüne und eine blaue Laserdiode ausgebildet sein, wobei die rote Laserdiode in der Diodenhalterung neben der blauen Laserdiode angeordnet ist.

Somit ist die Laserdiode, die den grössten Leistungsverlust bei höheren Temperaturen hat, neben der Laserdiode angeordnet, die die geringste Wärmeentwicklung aufweist. Dies optimiert die Funktion des Lichtmoduls.

Alternativ können zwei rote, eine grüne und eine blaue Laserdiode ausgebildet sein, wobei die zwei roten nebeneinander angeordnet sind, die grüne neben der roten und die blaue neben der grünen angeordnet ist.

Dadurch können die dichroitischen Spiegel einfacher ausgebildet sein, da sie keinen Bandpass darstellen müssen.

Das Lichtmodul kann eine Korrektureinheit umfassen, durch die Abweichungen des emittierten Lichtes einer Lichtquelle bezüglich des emittierten Lichtes einer zweiten Lichtquelle durch eine digitale Korrekturberechnung der Videodaten korrigierbar sind, sodass ein optimal überlagerter Strahl aus emittiertem Licht der Lichtquellen entsteht. Bevorzugt ist die Korrektureinheit durch eine Videobearbeitungsstrecke gebildet, insbesondere bevorzugt einen anwendungsspezifischen integrierten Schaltkreis (ASIC) bzw. einen Videokontroller.

Somit kann mit einem günstig hergestellten Lichtmodul ein scharfes und nicht verzerrtes Bild hergestellt werden.

Die Aufgabe wird weiterhin durch ein Lichtmodul gelöst, welches mit einem Verfahren wie vorhergehend beschrieben hergestellt ist.

Ein derartiges Lichtmodul weist optimierte Herstellungskosten auf.

Verfahren zum Betreiben eines Lichtmoduls, bevorzugt wie vorhergehend beschrieben, umfassend die folgenden Schritte:
- Erzeugen von Licht mit mindestens zwei, bevorzugt drei Lichtquellen, bevorzugt Laserdioden,
- Kollimieren des erzeugten Lichtes,
- Kombinieren des erzeugten Lichtes zu kombiniertem Licht, welches überlagert ist, in einer Strahlkombinationsvorrichtung,
- Ablenken des kombinierten Lichtes durch einen oder mehrere MEMS-Spiegel,
- Steuern des oder der MEMS-Spiegel und/oder der Lichtquellen durch eine Lichtquellensteuerung.

Der oder die MEMS Spiegel und/oder die Lichtquellen sind durch die Lichtquellensteuerung mit Korrektureinheit derartig ansteuerbar, dass Abweichungen in der Überlagerung zwischen dem Licht der einzelnen Lichtquellen korrigiert werden, insbesondere der Zeitpunkt der Laserpulse und die Laserleistung (Farbwert) angepasst werden.

Ein derartiges Verfahren führt zu unverzerrten, scharfen Abbildungen, wobei das Lichtmodul kostengünstig herstellbar ist.

Das kombinierte Licht oder jeweils das erzeugte Licht kann durch eine Strahlformungsvorrichtung, insbesondere ein Prismenteleskop geformt sein.

Somit wird die Abbildungsqualität höher.

Die Aufgabe wird weiterhin durch ein Computerprogrammprodukt gelöst, das direkt in den internen Speicher eines digitalen Computers geladen werden kann oder auf einem Medium gespeichert ist und Softwarecodeabschnitte umfasst, mit denen die Schritte wie vorhergehend beschrieben ausgeführt werden, wenn das Produkt auf einem Computer läuft.

Insbesondere ist das Computerprogrammprodukt in der Korrektureinheit ausgebildet.

Somit wird die Abbildungsqualität optimiert.

Das Computerprogrammprodukt kann eine Videobearbeitungsstrecke sein, die in Hardware oder in hardwarenaher Software in einem ASIC oder Videocontroller vor einer Lichtquellensteuerung, insbesondere Lasersteuerung, abgebildet ist und digitale Rechenoperationen umfasst, mit denen die Position und der Farbwert der projizierten Pixel korrigiert werden

Das Computerprogrammprodukt kann zur Steuerung eines oder mehrerer MEMS-Spiegels in einem Lichtmodul, insbesondere einem Lichtmodul wie vorhergehend beschrieben ausgebildet sein. Das Lichtmodul umfasst einen oder mehrere MEMS-Spiegel und eine Lichtquellenansteuerung, insbesondere Laseransteuerung, wobei der oder die MEMS-Spiegel und die Lichtquellen durch die Lichtquellensteuerung mit Korrektureinheit derartig ansprechbar sind, dass Abweichungen in der Überlagerung zwischen dem Licht einzelner Lichtquellen des Lichtmoduls korrigiert werden, insbesondere der Zeitpunkt der Laserpulse und die Laserleistung (Farbwert) angepasst werden.

Somit kann eine höhere Abbildungsqualität erzielt werden.

Zur Korrektur der Laser-Spot Abweichungen aufgrund fehlender individueller Ausrichtung der einzelnen Komponenten aufgrund von passiver Montage, also gleichzeitigem Aufsetzen optischer Elemente auf eine Bodenplatte, wird im Folgenden ein Korrekturverfahren beschrieben. Selbstverständlich kann die Korrektur der Laser-Spot Abweichungen auch ohne passive Montage zur Bildoptimierung angewendet werden.

Erfindungsgemäß kann eine Versetzung von Komponenten im optischen Pfad toleriert werden, wenn die einzelnen projizierten Farbkanäle, also insbesondere emittiertem Licht jeweils einer Lichtquelle, abhängig von ihrem individuellen Fehler derart in der digitalen Video-Verarbeitung des Projektors, also insbesondere Lichtmodul mit MEMS-Spiegel oder Spiegeln, korrigiert werden, dass die einzelnen Pixel der Farbkanäle trotz Divergenz innerhalb eines Frames eines Projektorbildes aufeinander zu liegen kommen, bevorzugt mit einer Genauigkeit von <0,25 Pixel.

Die Lage der projizierten Pixel bei einer Bildverzerrung aufgrund des optischen Pfades sei Projektor-Koordinate genannt.

Zur Korrektur der Abweichungen kann zunächst eine Verzerrung des Bildes anhand genau eines Referenzkanales ermittelt werden und bevorzugt Korrekturterme für jeden einzelnen Bildpunkt berechnet werden.

Durch die Verwendung nur eines Referenzkanales wird der benötigte Rechen- und Speicherbedarf reduziert.

Der Referenzkanal kann beispielsweise durch jegliche Lichtquelle gebildet werden.

Nach der Bestimmung der Korrekturterme für die Verzerrung kann jeweils ein Korrekturterm für den Versatz jedes einzelnen erzeugten Spots jedes Farbkanals relativ zum Referenzkanal bestimmt werden und auf den Korrekturterm der Verzerrung aufaddiert werden.

Der Korrekturterm für den Versatz ist von geringerer Ordnung als der Korrekturterm für die Verzerrung, so dass ein optimales Bild mit geringerer Rechenleistung erzielt wird.

Insbesondere ist erfindungsgemäß, dass zur Korrektur einer Bildverzerrung (z.B. Verdrehung, Kissenverzerrung, Trapezverzerrung oder anderweitiger Abweichung höherer Ordnung von der Idealgeometrie), die beim Flying-Spot Laser Raster-Scanner immer durch den optischen Pfad entsteht, zunächst eine Verzerrungskorrektur mit einem Korrekturterm für nur einen Referenzkanal, also einen Farbkanal, ermittelt wird, mit dem alle Bildpunkte der Video-quelle (Anordnungsgeometrie z.B. recht-winklige Darstellung mit 16:9 Format) in das System der Projektor-Koordinaten überführt werden können, die in der Regel stark vom rechtwinkligen Video-Format der Bildquelle abweichen.

Der Referenzkanal, der für diese Bildverzerrungskorrektur verwendet wird, kann einer der genutzten Laserkanäle sein, es kann aber auch beispielsweise der geometrische Mittelpunkt aus allen Laserkanälen gewählt werden, um die Korrekturterme zu ermitteln. Jedenfalls wird zur Bildverzerrungskorrekturbestimmung nur ein Kanal verwendet.

Durch Fehljustage im Strahlengang, insbesondere durch Fehljustage von Komponenten innerhalb des Lasermoduls, kann es zu einem Versatz der Spots (Pixel) der unterschiedlichen Laser in der Projektionsebene kommen. Erfindungsgemäß wird die Korrektur dieses Versatzes innerhalb der Video-Bearbeitungssequenz erst nach der Verzerrungskorrektur des Referenzkanals durchgeführt. Wie oben beschrieben wird die Verzerrungskorrektur mit einem Polynom höherer Ordnung durchgeführt, beispielsweise mit einem Polynom 5. Ordnung. Die translatorische Korrektur der Lage (Versatz) jedes aktiven Farbkanals relativ zum Referenzkanal wird insbesondere mit einem Polynom niedrigerer Ordnung ermittelt (z.B. 3. Ordnung) und auf die Verzerrungskompensation des Referenzkanals addiert. Damit erfolgt die rechenintensive Verzerrungs-Korrektur nur für einen Referenzkanal und die einfachere Versatz-Korrektur für jeden Laserkanal mit einem einfacheren Polynom.

Durch die Auftrennung der Verzerrungskorrektur mit einem höherwertigen Polynom im Referenzkanal (1 Kanal) und der farbkanalspezifischen translatorischen Korrektur (3-4 Kanäle) mit einem Polynom geringerer Ordnung wird erreicht, dass der Flächenbedarf für Speicherzellen, der Leistungs- und Rechenbedarf für die digitale Schaltung zur Pixelkorrektur stark reduziert wird.

Im Folgenden wird die Erfindung in Ausführungsbeispielen näher erläutert. Hierbei zeigt
Fig. 1 zeigt eine schematische Darstellung eines Lichtmoduls,
Fig. 2 zeigt eine perspektivische Ansicht eines Lichtmoduls,
Fig. 3 zeigt eine schematische Darstellung eines Lichtmoduls mit MEMS-Spiegel,
Fig. 4 zeigt beispielhaft eine Bildverzerrung im Projektorkoordinatensystem (Sterne) gegenüber dem unverzerrten Bild (Kreuze),
Fig. 5 zeigt einen Pixelversatz im Projektorkoordinatensystem bei einem Versatz zweier Laserkanäle,
Fig. 6 zeigt den schematischen Ablauf der spezifischen Korrektur von translatorischem Versatz von unterschiedlichen Laserkanälen.

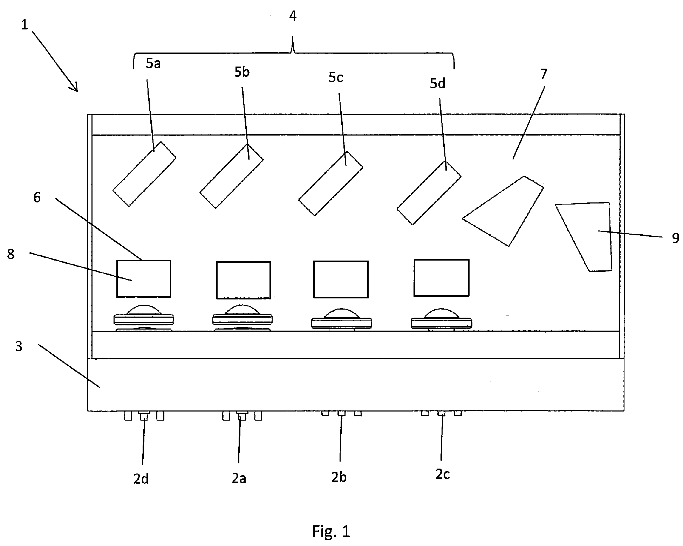

Figur 1 zeigt eine schematische Darstellung eines Lichtmoduls 1 mit vier Lichtquellen 2, die in der Lichtquellenhalterung 3 eingepresst sind. Die Lichtquellen 2 sind Laserdioden, wobei die Laserdiode 2a rotes Lichts emittiert, die Laserdiode 2b blaues Licht emittiert und die Laserdiode 2c grünes Licht emittiert. Zusätzlich ist eine zweite rote Laserdiode 2d ausgebildet. Um das Licht der zwei roten Laserdioden 2a, 2d in der Strahlkombinationsvorrichtung 4 kombinieren zu können, ist bei einer der beiden Laserdioden eine Polarisationsanpassungsvorrichtung (nicht dargestellt) ausgebildet. Die Strahlkombinationsvorrichtung 4 umfasst vier dichroitische Spiegel 5a, 5b, 5c und 5d. Sämtliche Elemente der Strahlkombinationsvorrichtung 4 sind gleichzeitig auf die Bodenplatte 7 aufgesetzt und befinden sich somit in einem vordefinierten Toleranzbereich. Zwischen den jeweiligen Laserdioden 2a, 2b, 2c und 2d und der Strahlkombinationsvorrichtung 4 ist je ein Positionierungsmodul 8 mit je einer Kollimierungslinse 6 angeordnet. Die Kollimierungslinse 6 in dem Positionierungsmodul 8 ist asymmetrisch angeordnet, sodass der Abstand der Linse von den Seitenwänden senkrecht zur Ausbreitungsrichtung des Lichtes jeweils unterschiedlich ist. Das Lichtmodul 1 umfasst weiterhin ein Strahlformungsmodul 9 in Form eines Prismenteleskopes. Das Strahlformungsmodul 9 wird gleichzeitig mit der Strahlkombinationsvorrichtung 4 auf die Bodenplatte 7 aufgesetzt. Die Elemente der Strahlkombinationsvorrichtung 4 und des Strahlformungsmoduls 9 werden nach dem Aufsetzen auf die Bodenplatte 7 nicht weiter einzeln ausgerichtet.

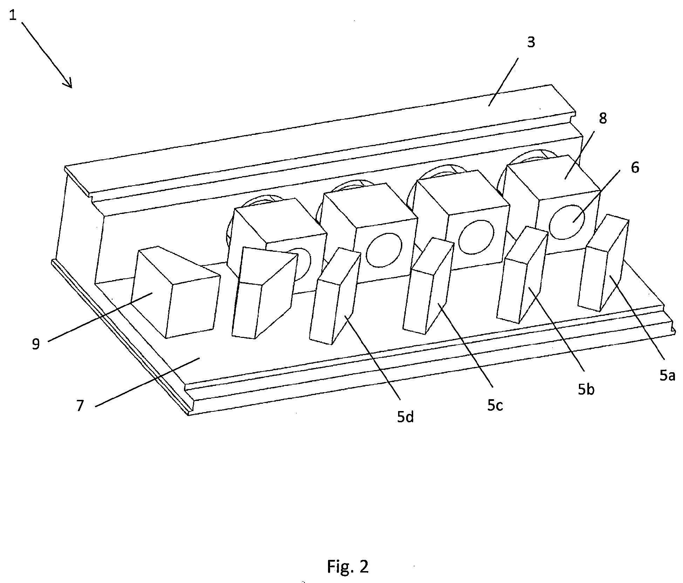

Figur 2 zeigt eine perspektivische Ansicht des Lichtmoduls gemäss Figur 1. In der perspektivischen Ansicht ist die Kollimierungslinse 6 im Positionierungsmodul 8 erkennbar, die innerhalb des Positionierungsmoduls 8 asymmetrisch angeordnet ist. Somit ist der Abstand der Kollimierungslinse 6, bzw. ihres Linsenmittelpunktes von den Seitenflächen, die sich nicht in Ausbreitungsrichtung des Lichtes befinden bzw. nicht zu den Lichtquellen 2 (siehe Figur 1) hin gerichtet sind, jeweils unterschiedlich.

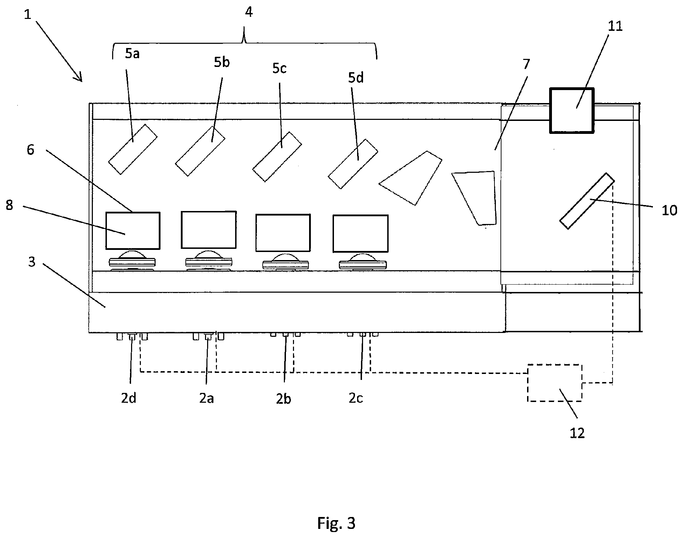

Figur 3 zeigt ein Lichtmodul gemäss Figur 1, wobei das Lichtmodul 1 weiterhin einen MEMS-Spiegel 10 und eine Lichtquellensteuerung 12 mit Korrektureinheit umfasst. Der MEMS-Spiegel 10 und die Lichtquellen 2 sind durch die Lichtquellensteuerung 12 mit Korretureinheit derartig angesprochen, dass Abweichungen von einer optimalen Überlagerung der emittierten Strahlung der einzelnen Lichtquellen bei der Projektion durch den MEMS-Spiegel 10 korrigiert werden, insbesondere durch Anpassung des Zeitpunktes der Laserpulse und der Laserleistung. Eine derartige Korrektur wird durch eine Korrektureinheit erzielt, die vorzugsweise als Videobearbeitungsstrecke in die Steuerung des MEMS-Spiegels 10 und der Lichtquellen 2 in die Lichtquellensteuerung 12 integriert ist. Das durch den MEMS-Spiegel 10 abgelenkte Licht wird durch Austrittsfenster 11 auf eine Projektionsfläche geleitet.

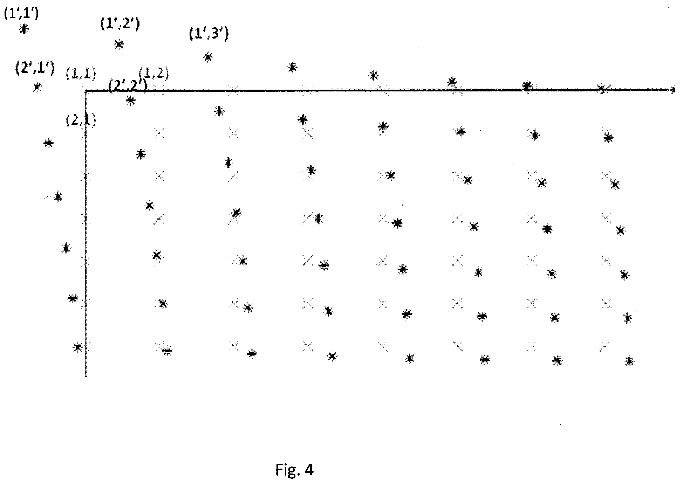

Figur 4 zeigt das Prinzip der Überführung der Koordinaten einer Bild oder Video-Quelle (beispielsweise 16:9, recht-winklige Geometrie, 854x480 Auflösung) in das Zielkoordinatensystem des Projektors (nicht-rechtwinklige Geometrie aufgrund Verzerrung durch optischen Pfad). Im linken oberen Teilausschnitt des Projektionsbildes sind jeweils die Verschiebung exemplarischer einzelner Bildpunkte vom Koordinatensystem der Bild- oder Videoquelle (1,1), (1,2) oder (2,1) ins Projektorkoordinatensystem (1',1'), (1',2') oder (2',1') gezeigt. Diese Bildverzerrung muss mit einem Korrekturterm relativ hoher Ordnung, beispielsweise fünfter Ordnung, eliminiert werden. Dies wird ausschliesslich für den Referenzkanal durchgeführt. Als graue Kreuze sind die Zielkoordinaten der unverzerrten Bilddarstellung gezeigt. Die Geometrie ist i.d.R. rechtwinklig, wie es beispielsweise bei Standard-Displays der Fall ist. Die Bildpunkte liegen typischerweise äquidistant innerhalb einer Zeile bzw. einer Spalte.

Aufgrund des Strahlenganges kommt es in einem Flying Spot Laser-Raster-Scanner immer zu einer Abweichung von der idealen Pixel-lage, so dass die Pixel im Projektor-Koordinatensystem stark von der Zielgeometrie abweichen können (siehe schwarze Sterne).

Bei einem unkorrigierten Pixel-Videostrom würde also hier der Pixel mit der Koordinate (1,1) in der Zielgeometrie (obere linke Ecke im eingezeichneten Rechteck) tatsächlich vom Projektor nach oben links verschoben dargestellt werden (obere linke Ecke des Projektorkoordinatensystems mit Koordinate (1',1')). Somit wird nahezu jeder Bildpunkt der Videoquelle durch Verzerrung nicht exakt auf die Koordinate in der Zielgeometrie abgebildet.

Bei der Verzerrungskorrektur werden nun die Koordinaten des Projektorkoordinatensystem (schwarze Sterne) mit den Farbwerten des ursprünglichen Videobildes in der Zielgeometrie (graue Kreuze) verknüpft. Damit wird der Farbwert der Projektorkoordinate (2', 2') beispielsweise durch eine Interpolation der Videokoordinaten (1,1) und (1,2) ermittelt. Diese Korrektur wird umso kleiner, je geringer die Abweichung zwischen Projektorkoordinate und Zielkoordinate bzw. Video-Koordinate ist. Die Abweichung kann mittels eines Kamerasystems ermittelt werden. Daraus werden Korrekturterme für jeden Bildpunkt errechnet (Polynomkorrektur z.B. 5. Ordnung).

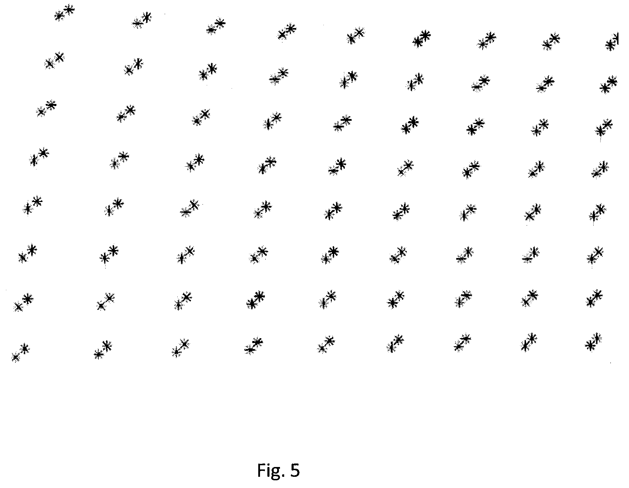

Figur 5 zeigt den Pixelversatz im Projektorkoordinatensystem bei einem Versatz zweier Laserkanäle. Die Korrektur dieses Versatzes kann mit einem geringen Restfehler bereits mit Korrekturtermen niedrigerer Ordnung erfolgen.

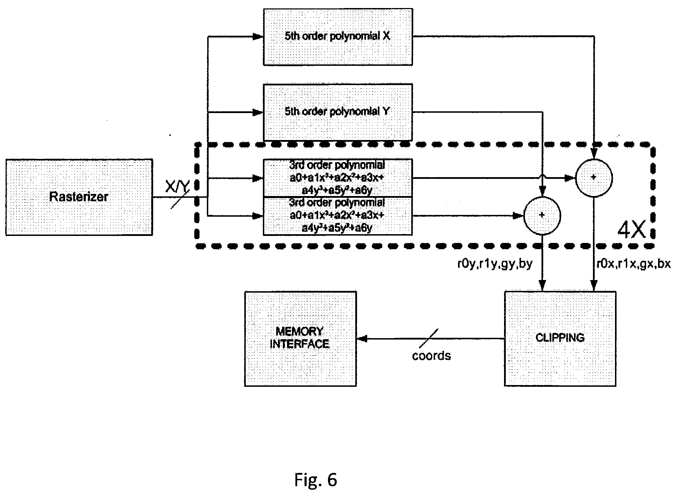

Figur 6 zeigt das grundlegende Schema der Pixel-Translationskorrektur. Hierbei sind die Funktionsblöcke:
Rasterizer: Der Rasterisierer definiert das nichtlineare Koordinatensystem der Projektion (Projektor-Koordinaten), dessen Lage von den Geometrien im Laser-Scanner entlang des optischen Pfades abhängig ist (Einfallswinkel Laser zu beweglichen Spiegelachsen, Winkel zwischen den MEMS-Spiegel-Achsen, Scanwinkel). Hierzu werden Verzerrungsparameter mittels eines Kamerasystem eingelesen.

5th order polynomial X (Y): Neuberechnung der Pixel-Information für den Referenzkanal im Raum der Projektorkoordinaten für X- und Y-Koordinate aus den Werten der Video-Quelle (Standard Videoformat/-geometrie). Hier spezifisch: Korrektur mit Polynom fünfter Ordnung.

3rd order polynomial: zusätzliche Korrektur der Pixel-Lage je Farbkanal bezogen auf den Referenzkanal mit einem Polynom niedrigerer Ordnung (hier spezifisch dritter Ordnung).

R0y, r1y, gy, by, ...: Errechnete Intensitätswerte für die Farbkanäle im Raum der Projektorkoordinaten (hier werden exemplarisch zwei rote Kanäle r0 und r1, ein grüner g und blauer Kanal b angewendet).

Clipping: aufgrund der nichtlinearen optischen Geometrieverzerrung des Laser-Rasterscanners werden Koordinaten im Projektorkoordinatensystem angefahren, die nicht mit entsprechenden Farbwerten aus dem Koordinatensystem der Videoquelle belegt sind; diese Koordinaten werden bei der Projektion schwarz oder transparent geschaltet.

## Patentansprüche

1. Verfahren zur Herstellung eines Lichtmoduls (1), umfassend die folgenden Schritte
- Platzieren, insbesondere Einpressen von mindestens zwei, bevorzugt drei, Lichtquellen (2a, 2b, 2c, 2d), insbesondere Laserdioden, in eine Lichtquellenhalterung (3), insbesondere Diodenhalterung,
- Setzen einer Strahlkombinationsvorrichtung (4), welche mindestens einen dichroitischen Spiegel (5) pro Laserdiode umfasst, wobei die jeweiligen dichroitischen Spiegel (5) einen Abstand zueinander aufweisen,
- Platzieren von jeweils einer Kollimationslinse (6) vor den Laserdioden auf einer Bodenplatte (7), so dass das aus den Laserdioden emittierte Licht kollimiert wird, bevorzugt mit einer Kollimationslinse (6) in einem Positionierungsmodul (8),
**dadurch gekennzeichnet, dass**
die dichroitischen Spiegel (5) gleichzeitig auf die Bodenplatte (7) aufgesetzt werden.

2. Verfahren nach Anspruch 1, **dadurch gekennzeichnet, dass** die einzelnen dichroitischen Spiegel (5) so gesetzt werden, dass ihre Position und Lage innerhalb eines vordefinierten Toleranzbereiches voneinander angeordnet ist, wobei der Toleranzbereich im Bereich von +/-0.01 mm, insbesondere +/-0.005 mm, in der Position der dichroitischen Spiegel (5) voneinander und/oder die Lage im Bereich von +/- 4 mrad, insbesondere +/- 2 mrad bezüglich der Normalen der Bodenplatte und/oder bezüglich eines anderen dichroitischen Spiegels (5) liegt.

3. Verfahren nach Anspruch 1 oder 2, **dadurch gekennzeichnet, dass** weiterhin ein Strahlformungsmodul (9), insbesondere ein Prismenteleskop, gemeinsam gleichzeitig mit der Strahlkombinationsvorrichtung (4) auf die Bodenplatte (7)gesetzt wird, wobei sich bevorzugt auch die Prismen des Prismenteleskopes nicht berühren.

4. Verfahren nach einem der vorhergehenden Ansprüche, **dadurch gekennzeichnet, dass** wenigstens ein MEMS-Spiegel (10) so gesetzt wird, dass das emittierte Licht aus den Lichtquellen (2) nach Durchlaufen der Stahlkombinationsvorrichtung (4) und des Strahlformungsmoduls (9) auf den MEMS-Spiegel (10) trifft.

5. Verfahren nach einem der vorhergehenden Ansprüche, **dadurch gekennzeichnet, dass** Abweichungen des emittierten Lichts einer Lichtquelle (2) bezüglich des emittierten Lichts einer zweiten Lichtquelle (2) durch eine Software korrigiert werden, so dass ein optimal überlagerter Strahl aus emittiertem Licht der Lichtquellen (2) entsteht.

6. Lichtmodul (1) zur Erzeugung von Licht umfassend eine Lichtquellenhalterung (3), insbesondere Diodenhalterung, mit mindestens zwei, bevorzugt drei, Lichtquellen (2), insbesondere Laserdioden, bevorzugt eingepresste Laserdioden, jeweils einer Kollimationslinse (6) pro Lichtquelle, bevorzugt je einer Kollimationslinse (6) in je einem Positionierungsmodul (8), und einer Strahlkombinationsvorrichtung (4), die jeweils einen dichroitischen Spiegel (5) pro Lichtquelle (2) zur Kombination des von den jeweiligen Lichtquellen (2) emittierten Lichts umfasst, wobei die Lichtquellenhalterung (3), die Kollimationslinsen (6) und die Strahlkombinationsvorrichtung (4) bevorzugt auf einer Bodenplatte (7) angeordnet sind, **dadurch gekennzeichnet, dass** die dichroitischen Spiegel (5) innerhalb eines vordefinierten Toleranzbereiches voneinander angeordnet sind und einen Abstand zueinander aufweisen, wobei der Toleranzbereich im Bereich von +/-0.01 mm, insbesondere +/-0.005 mm, in der Position der dichroitischen Spiegel(5) voneinander und die Lage im Bereich von +/- 4 mrad, insbesondere +/- 2 mrad bezüglich der Normalen der Bodenplatte (7) und/oder bezüglich eines anderen dichroitischen Spiegels (5) liegt.

7. Lichtmodul (1) nach Anspruch 6, **dadurch gekennzeichnet, dass** das Lichtmodul (1) ein Strahlformungsmodul (9) umfasst, bevorzugt ein Prismenteleskop, welches bevorzugt auf der Bodenplatte (7) angeordnet ist und/oder eine Lichtquellensteuerung (12) umfasst, durch die die Lichtquellen (2) steuerbar sind..

8. Lichtmodul (1) nach einem der Ansprüche 6 oder 7, **dadurch gekennzeichnet, dass** das Lichtmodul (1) wenigstens einen MEMS-Spiegel (10) umfasst, der bevorzugt auf der Bodenplatte (7) angeordnet ist.

9. Lichtmodul (1) gemäss einem der Ansprüche 6 bis 8, **dadurch gekennzeichnet, dass** das Lichtmodul (1) eine Korrektureinheit umfasst, durch die Abweichungen des emittierten Lichts einer Lichtquelle (2) bezüglich des emittierten Lichts einer zweiten Lichtquelle (2) durch eine Software korrigierbar sind, so dass ein optimal überlagerter Strahl aus emittiertem Licht der Lichtquellen (2) entsteht.

10. Lichtmodul (1) hergestellt mit einem Verfahren gemäss einem der Ansprüche 1 bis 5.

11. Verfahren zum Betreiben eines Lichtmoduls (1), bevorzugt eines Lichtmoduls (1) gemäss einem der Ansprüche 6-10 umfassend die Schritte
- Erzeugen von Licht mit mindestens zwei, bevorzugt drei Lichtquellen (2), bevorzugt Laserdioden,
- Kollimieren des erzeugten Lichtes,
- Kombinieren des erzeugten Lichtes zu kombiniertem Licht in einer Strahlkombinationsvorrichtung (4),
- Ablenken des kombinierten Lichtes durch wenigstens einen MEMS-Spiegel (10),
- Steuern des MEMS-Spiegels und/oder der Lichtquellen durch eine Lichtquellensteuerung (12),
**dadurch gekennzeichnet, dass**
der wenigstens eine MEMS Spiegel (10) und/oder die Lichtquellen durch die Lichtquellensteuerung (12) derartig ansprechbar sind, dass Abweichungen in der Überlagerung zwischen dem Licht der einzelnen Lichtquellen korrigiert werden.

12. Verfahren nach Anspruch 11, **dadurch gekennzeichnet, dass** zur Korrektur der Abweichungen zunächst die Verzerrung anhand genau eines Referenzkanales ermittelt wird und bevorzugt Korrekturterme für jeden einzelnen Bildpunkt berechnet werden.

13. Verfahren nach Anspruch 12, **dadurch gekennzeichnet, dass** nach der Bestimmung der Korrekturterme für die Verzerrung jeweils ein Korrekturterm für den Versatz jedes einzelnen erzeugten Spots jedes Farbkanals relativ zum Referenzkanal bestimmt wird und auf den Korrekturterm der Verzerrung aufaddiert wird.

14. Computerprogrammprodukt das direkt in den internen Speicher eines digitalen Computers geladen werden kann oder auf einem Medium gespeichert ist und Softwarecodeabschnitte umfasst, mit denen die Schritte gemäß einem der Ansprüche 11-13 ausgeführt werden, wenn das Produkt auf einem Computer läuft.

15. Computerprogrammprodukt gemäss Anspruch 14 zur Steuerung wenigstens eines MEMS-Spiegels (10) und/oder eine Lichtquellensteuerung (12) in einem Lichtmodul, insbesondere einem Lichtmodul gemäss einem der Ansprüche 6-10, wobei das Lichtmodul wenigstens einen MEMS-Spiegel (10) und eine Lichtquellensteuerung (12) umfasst, wobei der wenigstens eine MEMS-Spiegel (10)und/oder die Lichtquellen (2) derartig ansprechbarsind, dass Abweichungen in der Überlagerung zwischen dem Licht einzelner Lichtquellen (2) des Lichtmoduls (1) korrigiert werden.
